# EUROPEAN PATENT SPECIFICATION

(11) **EP 3 167 495 B1**
(45) Date of publication and mention of the grant of the patent: **02.01.2019**
(21) Application number: 14780551.9
(22) Date of filing: 08.08.2014
(51) Int. Cl.: H01L 39/16

(54) **CURRENT LIMITER ARRANGEMENT AND METHOD FOR MANUFACTURING A CURRENT LIMITER ARRANGEMENT**
STROMBEGRENZUNGSANORDNUNG UND VERFAHREN ZUR HERSTELLUNG VON EINER STROMBEGRENZUNGSANORDNUNG
ARRANGEMENT D'UN LIMITEUR DE COURANT ET PROCÉDÉ DE FABRICATION D'UN ARRANGEMENT D'UN LIMITEUR DE COURANT

(43) Date of publication of application: 17.05.2017
(73) Proprietor: Furukawa Electric Co. Ltd., Tokyo 100-8322 (JP)
(72) Inventor: MIHÁLFFY, Tamás, 1158 Budapest (HU); YOKOYAMA, Shinji, Tokyo 100-8322 (JP); MATSUI, Masakazu, Tokyo 100-8322 (JP); VARGA, Gábor, 1158 Budapest (HU); HERNÁDI, Zoltán, 1158 Budapest (HU); KASAHARA, Hajime, Tokyo 100-8322 (JP)
(74) Representative: Horn Kleimann Waitzhofer Patentanwälte PartG mbB
(86) International application number: PCT/IB2014/001495
(87) International publication number: WO 2016/020715

(56) References cited:
- JP-A- 2005 217 039
- JP-A- 2009 259 520

## Description

### FIELD OF INVENTION

This disclosure relates to a current limiter arrangement and a method for manufacturing a current limiter arrangement. In particular, the disclosed current limiter arrangement and current limiting devices employed therein can be used as superconductor fault current limiter (SFCL) for limiting an electric current between two terminals.

### BACKGROUND

Current limiting devices are employed in electric power transmission and distribution systems. In transmission grids, the rapid variation of currents, for example due to lightning, grounded wires, non-intended interference with power lines etc. can lead to short circuit conditions. This can lead to a sharp surge in current which is sometimes also called a fault current. In order to minimize damage due to fault currents, current limiting devices are employed. In particular, superconductor-based fault current limiters (SFCL) are widely used as current limiting devices in power grid systems.

Superconductors, especially high temperature superconducting (HTS) materials, have a variable impedance or resistance depending on their operating conditions, such as temperatures or currents running through an HTS material. Under normal and stable operating conditions, a superconductor material exhibits virtually no electrical resistance. However, when the electrical current flowing through a superconductor material increases above a specific critical value, the superconducting properties may collapse. As a result, a normal conductive state appears, and due to the resistance the temperature increases potentially above the material's critical temperature. As a result of the non-zero resistance, the fault current is reduced or limited. After the short circuit condition is resolved and the fault current is eliminated, the current flow through the superconductor and the temperature may decrease again, and the superconductor fault current limiter returns to its superconducting state.

The time period until the superconducting state is assumed again is also called the recovery time and depends on how quick the SFCL system is cooled down below the critical temperature of the superconducting material. Generally, it is desirable to minimize the recovery time in SFCLs. Attempts in reducing the recovery time include the use of monocrystalline superconductors instead of polycrystalline materials, tube-shaped powder arrangements or the use of particular material compositions.

In order to improve the capability of handling high fault currents and high nominal currents under normal operating conditions, sometimes fault current limiters are arranged in parallel/or in series to form an array. Due to variations in the manufacturing process for the individual current limiting devices and different properties of the materials used in the SFCL devices, the current limiting properties, especially the recovery times, in an array built from single SFCL devices may be different for different SFCL devices. This can result in inhomogeneous current densities through the array of SFCL devices and asynchronized triggering of the devices. It is however desirable to have a uniformly distributed current through the devices at all operational conditions, which depends on several factors described below. Reference is likewise made to the prior art documents JP2009259520 and JP2005217039.

It is therefore an object to provide an improved current limiter arrangement and a method for manufacturing such.

### BRIEF SUMMARY OF THE INVENTION

The current invention is directed to a current limiter arrangement according to the independent device claim 1 and a method for manufacturing a current limiter arrangement according to the independent method claim 14.

According to another aspect a current limiting device for limiting an electric current between a first and a second terminal is disclosed. The current limiting device comprises: a substrate having a substrate surface area and a substrate thickness, a superconducting section arranged on the substrate and thermally coupled to the substrate thereby covering a coupling surface area on the substrate. The substrate longitudinally extends between the first and the second terminal. And a width of the substrate extends beyond the coupling surface area and varies at least piecewise between the first and the second terminal.

Embodiments of the current limiting device may include a substrate comprising at least two substrate sections that are at least section-wise separated from one another by a gap, wherein the superconducting section and/or a third substrate section partially bridges the gap. In embodiments the substrate is symmetrically shaped between the first and the second terminal. E.g. a symmetry axis can run half-way between the two terminals. A symmetric setup can facilitate a uniform cooling process and may enhance a mechanical durability of the current limiting device(s).

The substrate and the superconducting sections can be generally flat material areas. For example, the superconducting section can be a plate that is attached to the substrate in the coupling surface area. For example, the combination of a substrate and the superconducting section form a thin film superconducting plate.

The critical current value for the superconducting section can depend on the superconducting material used. Generally, the superconducting section influences the fault current limiter characteristics of the current limiter arrangement. Hence, by adapting the geometry of the substrate with respect to the superconducting sections, one can compensate variations in the electrical properties of the system by adapting, for example, the relationship of the width of the substrates and the superconducting sections. Because the individual geometry of the substrate and the superconducting section in the current limiting devices are adapted in dependence of the individual critical current one can modulate the recovery times. E.g. the relationships of the width of the substrate and the width of the superconducting section can change from device to device. A substrate surface area in the first current limiting device can be different from the substrate surface area in the second current limiting device.

In embodiments, the substrate surface areas, the substrate thicknesses and/or the coupling surface areas are implemented such that the recovery times of the first and the second current limiting device are within a predetermined range. In particular, when the current limiter device is operated, for example, at low temperatures where the superconducting sections show superconductivity, and a fault current occurs, locally, the current limiting devices heat up such that a normal conducting state occurs. After the fault current is eliminated, the superconducting state in the various superconducting sections returns after the specific recovery time for the device. In particular, the recovery times of the separate current limiting devices are matched so that the recovery times have essentially the same value within a predetermined range or tolerance. This is, for example, achieved by specifically choosing the geometry of the substrate and/or the superconducting section on the substrate for the various current-limiting devices.

In embodiments of the current limiter arrangement in at least one of the first or second current limiting device, the substrate surface area is larger than the coupling surface area. For example, the surface area, in particular on the side facing to the superconducting section is larger than the surface area of the superconducting section facing the substrate. The substrate can act as a heat sink or heat dissipating means. For example, the substrate can have a width which is larger than a width of the coupling surface area. In embodiments, the superconducting section can have a rectangular shape electrically coupling the two terminals. Then, the width of the superconducting section is smaller than the width of the substrate. In particular, the substrate can be adapted to predominantly lead to nucleate boiling of a surrounding coolant liquid.

In embodiments, at least one of the substrates varies in width along its longitudinal extension between the first and the second terminal. A width can be varied by changing the lateral extension beyond the lateral extension of the respective superconducting sections. E.g. restrictions, fins, cut-outs of the substrate material can be contemplated.

In embodiments of the current limiter arrangement, the substrate in at least one of the first or second current limiting devices comprises two substrate sections that are at least section-wise separated from one another by a gap. Then, the superconducting section and/or a third substrate section bridges the gap. Having a gap may change the heat dissipation from a heated-up superconducting section and thereby may change a recovery time. Having a gap and/or a width of the substrate which is larger than a width of the superconducting section may enhance nucleate boiling of a cooling liquid surrounding the substrate superconducting section systems. Generally, the substrate can rigidly support the superconducting section and is formed of one solid material. The substrate is, for example one plate that is shaped to obtain the desired heat dissipative properties.

It is understood that "section-wise" includes regions or areas of the substrate that have a convex geometry. Then edges of the substrate may have an angled relationship where a void exists between edges. A gap, for example, can be formed by edge portions of a shaped substrate plate that face towards each other at a specific distance.

In embodiments of the current limiter arrangement, the superconducting current limiting sections have essentially the same width. Having a standard width for the superconducting sections can render the fabrication easier while the geometry of the substrates can be varied to match the recovery times.

In another embodiment of the current limiter arrangement in at least one of the first or second current limiting device, the substrate thickness varies between the first and the second terminal. By varying, for example, the thickness or volume of the substrate attached to the superconducting section, the heat capacity of the substrate may be changed between current limiting devices so that preferably all current limiting devices exhibit the same or like recovery time.

In another embodiment of the current limiter arrangement, further current limiting devices are arranged between the first and the second terminal. Each current limiting device includes a substrate having a substrate surface area and a substrate thickness. A superconducting section is arranged on the respective substrate and is thermally coupled to the substrate thereby covering a coupling surface area on the substrate. Each of the superconducting sections has critical current value, and the substrate surface areas, the substrate thicknesses and/or the coupling surface areas are implemented as a function of the critical current values. For example, the plurality of current limiting devices is operated in parallel between the first and the second terminal.

Embodiments of the current limiter arrangement can further comprise a housing for the coolant fluid, wherein the cooling fluid passes around the current limiting devices. The coolant fluid or coolant liquid can be, for example, a cryogenic fluid such as liquid nitrogen. The cryogenic coolant fluid is preferably adapted to provide a temperature which is below the critical temperature of the superconducting material.

In embodiments of the current limiter arrangement, at least one of the current limiting devices, the substrate and the superconducting section, is a layered structure, for example the substrate can comprise a thermally conducting but electrically insulating material. Sapphire can be used as substrate material. The superconducting section, for example, comprises a buffer layer, a superconducting layer and a protective layer. The protective layer is, for example, a metal layer further establishing electrical contact to the terminals.

In embodiments, the substrate comprises an electrically isolating material that is adapted to dissipate heat from the superconducting section into a cooling liquid.

In embodiments, the substrate comprises a functionalized surface layer for facilitating a nucleate boiling of cooling fluid. Nucleate boiling can lead to an enhanced heat transport or heat dissipation from the superconducting section in order to obtain a shorter recovery time.

Further, a method for manufacturing a current limiter arrangement is disclosed. The method comprises the step of arranging a plurality of current limiting devices between a first and a second terminal wherein the current limiting devices each include a substrate having a substrate surface area and a substrate thickness, and a superconducting section arranged on the substrate and thermally coupled to the substrate thereby covering a coupling surface area on the substrate. The method comprises adapting the substrate surface areas, the substrate thicknesses and/or the coupling surface areas are a function of the critical current values of the superconducting sections.

Optionally, the method may comprise the step of electrically coupling the superconducting sections between the first and the second terminal wherein each of the superconducting section has a critical current value.

Further optionally, the method comprises the step of measuring a critical current of at least one of the current limiting devices, for example using a current measurement circuit.

For example, adapting the substrate surface areas, the substrate thicknesses and/or the coupling surface areas may comprise adjusting, tuning, varying or changing the geometric relationship between a substrate and a superconducting section assigned to the substrate. The method is in particular suitable for manufacturing a current limiter arrangement as disclosed above or below regarding specific examples.

The method may comprise compensating for a difference in recovery times of the current limiting devices by varying the geometric relationship between the substrates and the superconducting sections, for example by varying the substrate surface areas, the substrate thicknesses and/or the coupling surface areas.

Compensating a difference in recovery times is particularly useful when operational parameters of the current limiter arrangement are specified. For example, the operating parameters can include an operating temperature, the number of current limiter devices, the thicknesses of layers or the specific materials used as substrates and/or superconducting materials.

Certain embodiments of the presented current limiter arrangement, current limiting device or the method for manufacturing such may comprise individual or combined features or aspects as mentioned above or below with respect to exemplary embodiments. In particular, features relating to the current limiting devices and discussed with respect to the current limiter arrangement can be implemented in single current limiting devices as well.

### BRIEF DESCRIPTION OF THE DRAWINGS

In the following, embodiments of nanostructure devices for electronic circuits, circuit arrangements and methods for manufacturing are described with reference to the enclosed drawings.
Fig. 1 shows a top view of a first embodiment of a current limiter arrangement.
Fig. 2 shows a cross-sectional view of a layered structure suitable for use in a current limiting device.
Fig. 3 shows a cross-sectional view of a detail of the first embodiment of a current limiter arrangement according to Fig. 1.
Fig. 4 shows a schematic top view of a substrate-superconducting layer configuration for illustrating substrate surface areas and coupling surface areas.
Fig. 5 shows a schematic top view of a current limiter arrangement including several embodiments of current limiting devices.
Fig. 6 shows a cross-sectional view of another embodiment of a current limiting device.
Fig. 7 illustrates a flowchart for an embodiment for a method for manufacturing a current limiter arrangement.
Fig. 8 shows diagrams illustrating the effects of a critical current and a recovery time.
Fig. 9 shows a schematic perspective view of a further embodiment for a current limiting device suitable for a current limiter arrangement.
Fig. 10 shows a diagram illustrating the influence of a relation between the width of a superconducting section and a substrate on the recovery time for the embodiment of a current limiting device according to Fig. 9.
Fig. 11 shows a schematic perspective view of yet another embodiment for a current limiting device suitable for a current limiter arrangement.
Fig. 12 shows a diagram illustrating the influence of a gap width in the embodiment on the recovery time for a current limiting device according to Fig. 11.
Figs. 13 - 16 are schematic views of details in embodiments of current limiting devices.
Fig. 17 shows another embodiment for a current limiter arrangement.

Like or functionally like elements in the drawings have been allotted the same reference characters, if not otherwise indicated.

### DETAILED DESCRIPTION OF THE EMBODIMENTS

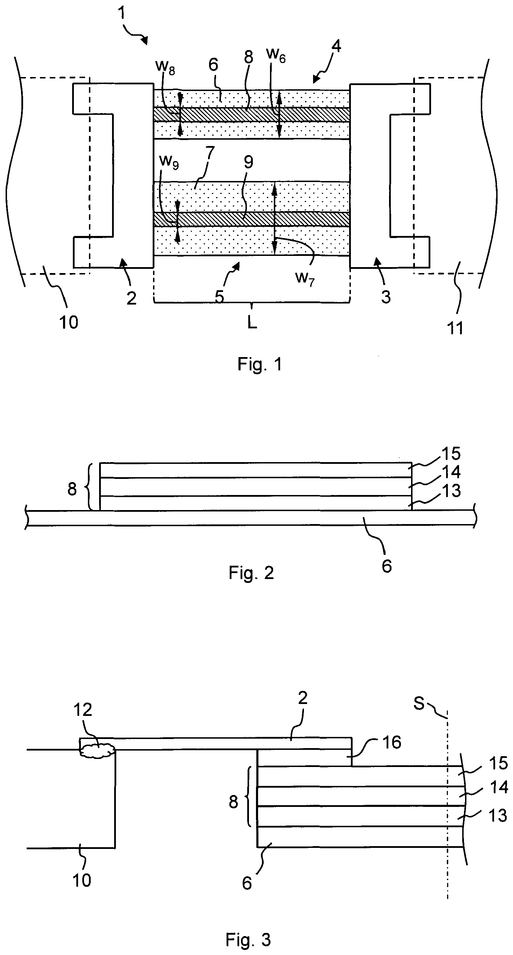

Fig. 1 shows a first embodiment of a current limiter arrangement 1 in a top view. The current limiter arrangement 1 is placed between two contact bars 10, 11. An electric current running through the current limiter arrangement 1, i.e. between the contact bars 10, 11, shall be limited if a fault occurs, for example if a surge in current due to a short circuit condition appears. The current limiter arrangement 1 comprises generally a plurality of separate current limiting devices. In the embodiment shown in Fig. 1, two current limiting devices 4, 5 are employed that each comprises a substrate 6, 7 for supporting a superconducting section 8, 9.

In the embodiment shown in Fig. 1, the substrates 6, 7 and the superconducting sections 8, 9 have a rectangular shape and extend between a first terminal 2 and a second terminal 3. The superconducting sections are thin film superconducting sections. In particular, the superconducting sections 8, 9 are electrically coupled to the terminals 2, 3 and allow for an electric current to flow between the first and the second contact bar 10, 11 via the terminals 2, 3. Under normal conditions current flows without an electric resistance.

The length of the strip-like superconducting sections 8, 9 is indicated by L. Further, the width of the first superconducting section 8 is W₈ and the width of the second superconducting section 9 is W₉. The widths of the respective substrates 6, 7 are W₆ and W₇. In embodiments, for example, the width of the superconducting section W₈, W₉ is between 20 and 50 mm. The length L of the superconducting strips 8, 9 and/or the substrates 6, 7 is, for example, between 10 and 30 cm. A typical thickness of a current limiting devices 4, 5 including the substrate 6, 7 and the superconducting section 8, 9 is, for example between 0.5 and 2 mm. One can speak of a plate-based current limiting film device 4, 5.

The current limiting devices 4, 5 comprising the substrates 6, 7 and superconducting strips or sections 8, 9 can have a layered structure. The combination of substrate 6, 7 and superconducting section 8, 9 is sufficiently rigid and stable to be held between the electrodes in a self-supporting fashion. Although not expressly shown, the current limiter arrangement 1 can comprise further SFCL devices connected in parallel to form an array of SFCL devices between the electrodes 2, 3 (the terminals).

Fig. 2 shows a cross-sectional view of, for example, the first current limiting device 4. The substrate 6 is, for example, an insulating member or a plate. The thickness can be between 0.5 and 2 mm, for example. In an embodiment, the substrate 6 comprises sapphire. A ceramic material can be used as substrate material as well. E.g. MgO, SrTiO₂, or yttrium-stabilized zirconia may be considered suitable for a plate-like substrate. In embodiments the substrate 6 has a single crystal structure Specific examples of a metal oxide material include Al₂O₃ (aluminum oxide, particularly sapphire), (Zr, Y)O₂ (yittria-stabilized zirconia), LaAlO₃ (lanthanum aluminate), SrTiO₃ (strontium titanate), (LaₓSr₁₋ₓ)(AlₓTa₁₋ₓ)O₃ (lanthanum-strontium-tantalum-aluminum oxide), NdGaO₃ (neodymium gallate), YAlO₃ (yttrium aluminate), MgO (magnesium oxide), TiO₂ (titania), and BaTiO₃ (barium titanate). Specific examples of the ceramic include silicon carbide and graphite. However, one may contemplate of other materials suitable as a substrate material. The above mentioned material can be used as substrate material in all embodiments.

The superconducting section 8 is arranged on the substrate 6. The superconducting section may comprise a first layer 13 or intermediate layer acting as a buffer layer. On the buffer layer 13, a superconducting layer 14 is face comprising a superconducting material. For example, a high temperature superconducting (HTS) material can be used. The superconducting layer 14 is covered with a protective layer 15 that may comprise a metal.

The intermediate layer 13 is formed on the substrate 6 and preferably allows for a high in-plane orientation of the superconducting layer 14. The average thickness of the intermediate or buffer layer 13 can be between 10 and 20 nm, and preferably between 10 nm and 15 nm. The intermediate layer 13 is, for example, formed through a vapor-deposition process using a mask for patterning and/or realizing a specific thickness. A surface roughness of the buffer layer is preferably adapted to improve an adhesion of the subsequent superconducting layer 14. The buffer layer can comprise a buffer material including, for example, CeO₂, and MgO having an NaCl-type crystal structure. In particular, the intermediate or buffer layer 13 can be shaped by ion beam assisted deposition (IBAD).

The superconducting layer 14 is formed on the buffer layer 13, and can comprise an oxide material as a main component of the superconducting material. The superconducting layer 14 is preferably a high-temperature superconductor (HTS) layer. HTS materials are typically chosen from any of the high-temperature superconducting materials that exhibit superconducting properties above the temperature of liquid nitrogen i.e. 77K. Suitable superconducting materials are, for example, YBa₂Cu₃O₇₋ₓ, Bi₂Sr₂CaCu₂O_{z}, Bi₂Sr₂Ca₂Cu₃O_{10+y}, Tl₂Ba₂Ca₂Cu₃O_{10+y} and HgBa₂ Ca₂Cu₃O_{8+y}. One class of materials includes (RE)Ba₂Cu₃O₇₋ₓ, wherein RE is a rare earth or combination of rare earth elements. It will be appreciated that non-stoichiometric and stoichiometric variations of such materials can be used, including for example, (RE)_{1.2}Ba_{2.1}Cu_{3.1}O₇₋ₓ. In particular, YBa₂Cu₃O₇₋ₓ is generally referred to as YBCO. YBCO may be used with or without the addition of dopants, such as rare earth materials, for example samarium.

The superconducting layer 14 is formed by known techniques including thick and thin film forming techniques. Preferably, a thin film physical vapor deposition technique such as pulsed laser deposition (PLD) can be used for a high deposition rates, or a chemical vapor deposition technique can be used for lower cost and larger surface area treatment. Typically, the superconducting layer has a thickness on the order of about 0.1 to about 30 microns, most typically about 0.5 to about 20 microns, such as about 1 to about 5 microns. The thickness is adapted to allow desirable amperage ratings associated with the superconducting layer 14.

The superconducting layer 14 is covered with a protective layer 15, wherein the protective layer 15 may also include a capping layer and a stabilizer layer, which are generally implemented to provide a low resistance interface and for reducing the risk of a superconductor burnout in use. More particularly, the protective layer 15 facilitates a continued flow of electrical charges along the superconductor material 14 in cases where cooling fails or the critical current density is exceeded due to a fault. Then, the superconducting layer 14 can change from the superconducting state and becomes resistive. Typically, a noble metal or a noble metal alloy is utilized for capping layer 15. Noble metals can include gold, silver, platinum, and palladium as protection materials. Various techniques may be used for depositing the protective layer 15, including physical vapor deposition, such as DC magnetron sputtering.

An optional stabilizer layer (not shown) can overlie the superconducting layer 14 and in particular, overlie and directly contact the metal protective layer 15. A stabilizer layer can be an additional protection or shunt layer to enhance stability against harsh environmental conditions and superconductivity quench. The stabilizer layer is, for example thermally and electrically conductive. It may be formed by any one of various thick and thin film forming techniques, such as by laminating a pre-formed copper strip onto the superconducting tape, by using an intermediary bonding material such as a solder. Other feasible processes include physical vapor deposition, typically evaporation or sputtering, as well as wet chemical processing such as electroless plating, and electroplating. In this regard, the layer 16 may function as a seed layer for deposition of copper thereon.

The thickness of the protective layer 15 is, for example, 100 and 300 nm. The protective layer is suitable to couple to an electrode, e.g. at least partially including a conductive member such as a gold-silver alloy.

In one embodiment, for example, the buffer layer comprises CeO₂ material. The superconducting material 14 is YBCO, and the protective layer 15 is an Ag-Au alloy.

However, one may contemplate of other materials suitable as a buffer material, a superconducting material or a protection material. The above mentioned materials can be used as respective materials in all embodiments.

Fig. 3 shows a detail in a cross-sectional view of the current limiting device 4. The layered structure comprising the substrate 6 and the superconducting section 8 is electrically coupled to the terminal 2 through an electrode 16, that for example comprises silver. The dashed-dotted line S is, for example, the symmetry axis S of the entire structure. The electrode 16 can be considered as part of the terminal member 2. The terminal 2 is soldered to the contact bar 10, for example with a solder material 12 that contains indium. The contact bar 10 can, for example, comprise a copper bar. To the left of the detail shown in Fig. 3 a similar contact bar, solder, terminal and electrode can be contemplated. Under normal circumstances, when no fault current occurs, electric current flows between the contact bars 10 and 11 (see Fig. 1) through the superconducting sections 8, 9 without resistance. This is, for example, achieved by cooling the current limiting devices 4, 5 below the critical temperature T_{c} of the used superconducting material.

The critical current I_{c} for each of the current limiting devices 4, 5 may differ from one another. This can be due to contact resistances between the actual superconducting material and the peripheral elements, as for example the protective metal layer 15, the electrode elements 2, 16, solder 12, but also due to in-homogeneities of the superconducting material itself and manufacturing differences. In principle, slightly different superconducting materials can be used in different current limiting devices 4, 5 forming the fault current limiter arrangement 1 (see Fig. 1). One can measure the critical currents I_{c} of the individual SFCL devices by injecting a current sweep through the SFCL 4, 5.

The critical currents of the individual devices 4, 5 can lead to a variation in the recovery times of the two devices 4, 5. One may define the recovery time tᵣ as the time interval that passes between the elimination of a fault and the change from normal or regular conductivity to superconductivity, when in operation of the device a current limiting event occurs. It is generally desirable to have little or no variations in the recovery time in a fault current limiter device or arrangement. In the embodiment shown in Fig. 1, for example, a variation of the recovery times for the first device 4 and the second device 5 is compensated for by changing the geometric relationships between the first substrate 6 and the superconducting section 8 on the one hand and/or the geometric relationship between the substrate 7 and the superconducting section 9 on the other hand. For example, this can be achieved through specific ratios of the surface area of the respective substrate with the coupling surface area where the superconducting section is thermally coupled to the respective substrate.

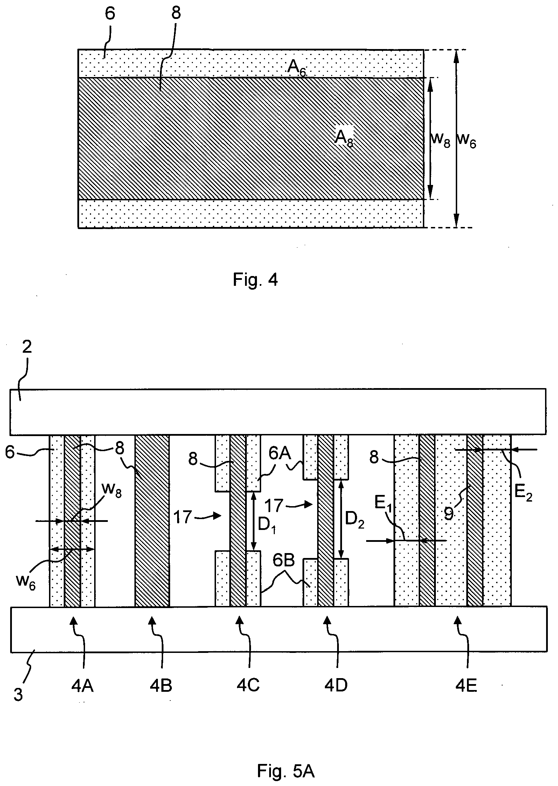

Fig. 4 is a schematic top view of a layered structure with a superconducting section 8 arranged on a substrate 6. In the configuration shown in Fig. 4, the substrate 6 and the superconducting strip or plate 8 have both a common length L. However, the width W₈ of the superconducting strip 8 and the width W₆ of the substrate 6 differ. The width W₈ of the superconducting strip 8 is smaller than the width W₆ of the substrate 6. As a result, the surface area A₆ = W₆ ×L of the substrate 6 is larger than the surface area As = W₈ ×L of the area of substrate which is covered by the superconducting section 8. The latter area As is referred to as a coupling surface area. It is understood that the coupling surface area As corresponds to the surface area of the superconducting section 8, when the superconducting section 8 is entirely placed on a substrate plate 6.

For example, in order to match the recovery times of the first and second current limiting device 4, 5 in the embodiment of Fig. 1., the width W₆ and W₇ of the corresponding substrates, and consequently, the area A₆ or A₇, respectively, can be different. For example. in the embodiment of Fig.1 the lower substrate 7 is wider than the upper substrate 6. Investigations of the applicant show that having a wider substrate than the superconducting strip or plate can reduce the recovery time. This is because the substrate extending in an area over the superconducting strip can act as a heat sink. I.e. heat may result from an electric current running through a resistive material, if, for example, the operating temperature or local temperature of the superconducting strip is higher than the critical temperature or the current fed through the superconducting material is higher than the critical current. Under these conditions the thermal energy needs to be dissipated so that the superconducting properties can be regained.

On the one hand, by increasing the width W₆, W₇ of the substrates 6, 7, a recovery time can be decreased because heat is better dissipated. Generally the larger the mass of the substrate the larger is its heat capacity. Heat generated by the superconducting strip 8 in its normal conduction state extends into the substrate 6 and is transferred in the substrate material and leads to boiling of coolant fluid at its surfaces. For example, a large surface area of the substrate that is in contact with the surrounding coolant may carry away heat from the superconductor 8 better than a small substrate. On the other hand, by varying the width W₆, W₇ with respect to each other, a homogeneous recovery time over all current limiting devices 4, 5 in the current limiter arrangement 1 can be obtained.

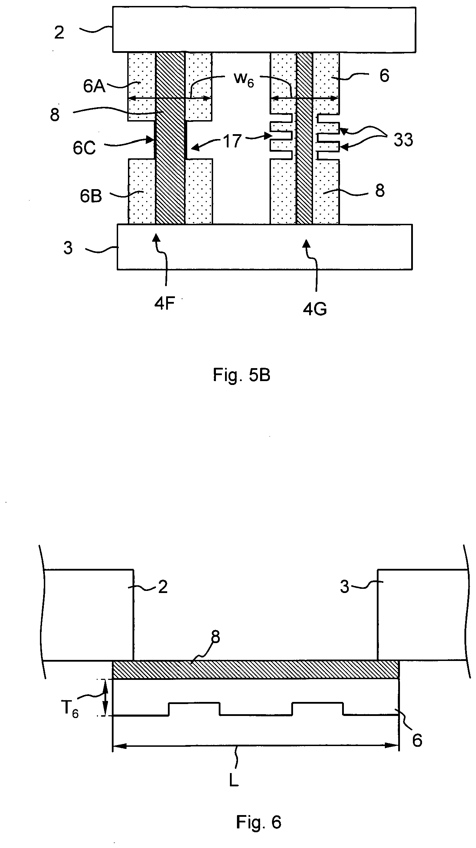

There are various options to vary or adapt the geometric relationship between the superconducting layer or section and the underlying substrate. Fig. 5 shows a variety of geometric configurations that can be employed to adjust the recovery times to be in a predetermined range. The predetermined range can correspond to a tolerance that is acceptable for each current limiting device in operating the current limiter arrangement.

Fig. 5, for the sake of simplicity, the substrates are designated with a common reference symbol 6, and the superconducting sections with a reference symbol 8. Fig. 5 is a top view showing a first and a second electrode 2, 3. From left to right, five exemplary geometric configurations for the spatial or geometric relationship between the superconducting strip 8 and the substrate 6 geometries are shown.

4A is an embodiment for a current limiting device where the substrate 6 and the superconducting section 8 have rectangular strip-like shape. The width W₆ of substrate 6 is larger than the width W₈ of the superconducting section 8. Hence, the substrate 6 is, for example, adapted to dissipate heat from the superconducting section 8 into a cooling liquid that may surround the device 4A. The wide substrate plate 6 can facilitate nucleate boiling for effectively transporting heat away from the superconducting strip 8.

4B shows a device where the substrate (not visible) and the superconducting layer or section 8 have the same shape. In the view shown in Fig. 5, the superconducting section 8 completely covers the substrate as W₆ is equal to W₈ (not shown).

4C and 4D show embodiments for current limiting devices 4C, 4D where the substrate comprises two sections 6A and 6B which are separated from each other by a gap 17. The gap 17 is bridged by the superconducting section 8 which are electrically coupled to the upper and lower terminals 2, 3. It can be shown that by varying the distance D₁, D₂ between the substrate sections 6A, 6B along the length L, the heat dissipating properties change well. Hence, by varying a gap distance D₁, D₂, also the resulting recovery times can be modified.

The current limiting device 4E has one substrate 6E on which two parallel superconducting strips 8, 9 are placed. One can also show that the distance E₁ from the edge of the substrate 6 to the superconducting section or strip 8, 9 can influence the heat dissipating properties so that by varying the distances E₁, E₂ between the edges of the substrate 6E and the superconducting sections 8, 9, a change in the recovery times can be obtained.

4F and 4G are embodiments where the width W₆ of the substrate 6 varies along the longitudinal extension of the substrate between the two terminals 2, 3. 4F has a geometry similar to 4C and 4D and a third substrate section 6C bridging the two sections 6A and 6B. 6C is covered by the superconducting strip 8 and is therefore not visible in the Fig. The entire substrate 6A, 6B, 6C is one piece and supports the superconducting strip 8 between the terminals 2, 3.

In 4G the substrate 6 has cut-outs forming gaps 17 and changing the total substrate area that is in contact with a coolant fluid. The substrate 6 therefore comprises fins 33 extending laterally from the superconducting section. By changing the number of cut-outs 17 or fins 33, respectively, the heat capacity of the substrate and consequently the cooling characteristics can be adapted. As a result, the recovery time of a current limiting device 4A - 4G may be tuned by changing the substrate. Also the geometry of the fins 33 can influence the heat dissipation properties of the substrate 6.

Generally, the substrate 6 can have an irregular shape and it can in particular vary with respect to different current limiting devices in a current limiter arrangement.

It is understood that a current limiter arrangement according to this disclosure can comprise any combination of the above elaborated geometries for adjusting or modulating a recovery time. In embodiments one of the configurational options 4A... 4G is used in a current limiter arrangement.

Fig. 6 shows a schematic cross-sectional view of another current limiting device. While in Fig. 5, generally the surface area of the substrate 6 facing the superconducting strip 8 is changed, Fig. 6 shows a variation of the thickness T₆ of the substrate 6. Again, the superconducting section 8 is electrically coupled between the first and the second terminal 2, 3. Along the length L of the substrate 6, the thickness T₆ of the substrate varies. By changing the thickness of the substrate 6, for example from one current limiting device to another, the heat dissipating properties of the substrates 6 may change so that the recovery times can be adjusted to each other. Generally the mass of the substrate 6 depends on the thickness and lateral extension. In turn the heat capacity of the substrate 6 depends on the mass so that indirectly the recovery time is modulated by the 3D shape of the substrate 6.

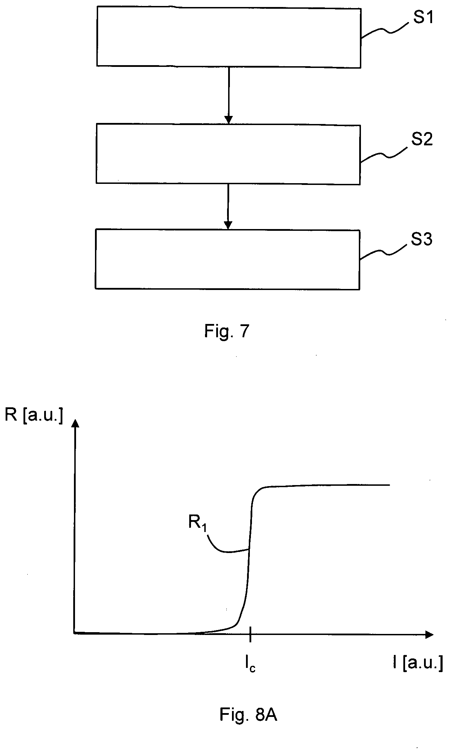

Fig. 7 shows a flowchart for a method for manufacturing a current limiter arrangement as for example shown in Fig. 1. The method is explained also referring to Fig. 1.

In a first method step S1 for manufacturing such an arrangement, a plurality of current limiting devices 4, 5 are arranged between a first and a second terminal 2, 3. The current limiting devices 4, 5 can each include a substrate 6, 7 having a substrate surface area and a substrate thickness. The current limiting devices 4, 5 further comprise a superconducting section 8, 9 arranged on the respective substrate 6, 7 wherein the superconducting section 8, 9 is thermally coupled to the substrate 6, 7 thereby covering a coupling surface area on the substrate 6, 7. As explained above, due to various effects, as for example an inhomogeneity of the superconducting material, a contact resistance towards the terminals or by other reasons the critical currents of the various current limiting devices 4, 5 need not be equal to one another.

In an optional step S2, the superconducting sections 8, 9 are electrically coupled to the first and the second terminal 2, 3. The superconducting sections 8, 9 can have each a specific critical current value.

Finally, in a step S3, the substrate surface areas, substrate thicknesses and/or the coupling surface areas are adapted as a function of the critical current values. This can lead to a compensation of a difference in recovery times of the individual current limiting devices 4, 5. In particular by adjusting, tuning, varying or adapting the substrate surface areas, the substrate thicknesses and/or the coupling surface areas, one may compensate for a difference in recovery times.

When adjusting the geometric relationships between the superconducting sections 8, 9 and the associated substrates 6, 7, an operating temperature, the number of devices, the thicknesses of the layers and other operational parameters for the current limiter arrangement 1 can be considered and taken into account for.

Preparative for the production of SFCL devices and arrays can be a labeling or measuring step for obtaining the critical current values for the individual devices.

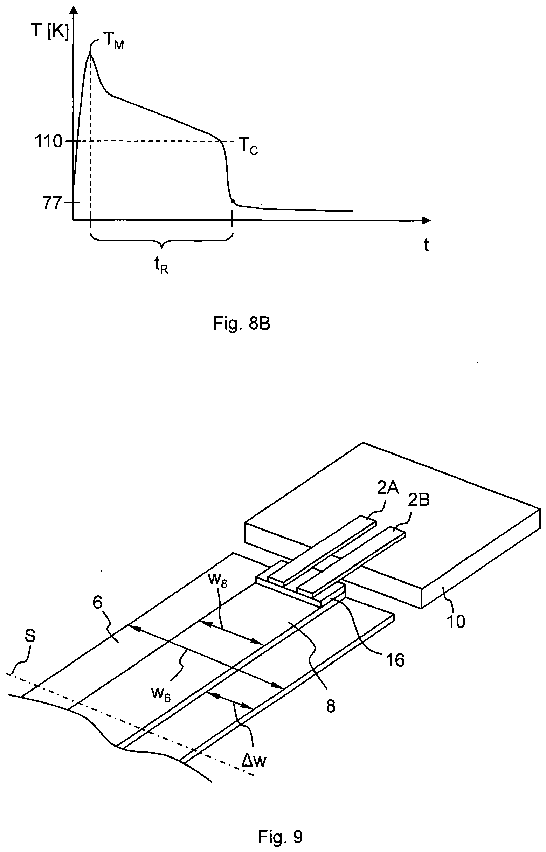

Fig. 8 shows diagrams for illustrating the superconducting properties in a current limiter arrangement. In Fig. 8A, a curve R1 is shown depicting the resistance of an exemplary superconducting section in a current limiting device as a function of the electrical current. The diagram shows arbitrary units (a.u.). If the current is running through the superconducting material of the superconducting section (see, for example, Fig. 1), the resistance is zero. However, if the current exceeds the critical current Ic, the superconducting material quenches and falls into a normal conductivity state. When this happens, the electrical current running through the current limiting device is subject to the emerging resistivity. Hence, the fault current is suppressed by the (fault) current limiting device. When this happens, the superconducting section including the intermediate layer 13, the superconducting layer 14 and the metal protective layer 15 (see, for example, Fig. 2) heats up. Consequently, the temperature increases due to the non-superconducting resistivity value.

Fig. 8B shows the time t dependence of the temperature T in or at the superconducting section, when a fault current event occurs. When high Tc-materials are used, superconductivity sets in, usually below 110 degrees Kelvin. Hence, a cryogenic fluid, as for example liquid nitrogen, can be used as a coolant fluid. Due to a high electric fault current the resistance or resistivity becomes "normal", and the temperature rises to a maximum which is well above 110 Kelvin, i.e. above the critical temperature T_{c} for superconductivity and above the boiling temperature of the cooling fluid. The cooling fluid boils up, which takes heat away from current limiting device. For better heat transfer, nucleate boiling is preferred against film boiling as described below. In particular, with the help of the cooling fluid surrounding the superconducting section and the substrates, the temperature decreases relatively rapidly and reaches the critical temperature T_{c} after some time. At that point, superconductivity sets in again. One may define the recovery time of a device as the time between the maximum temperature Tₘ after a current fault event and the transition to superconductivity state, i.e. a temperature below T_{c}. It is generally desirable to have a relatively small recovery time tᵣ.

Figs. 9 - 12 illustrate the influence or impact of specific geometric parameters of the substrate and the superconducting layer or section on the recovery time of a SFCL device.

In Fig. 9, a perspective schematic view of a detail of an embodiment for a current limiting device is shown. In Fig. 9, only one half of the current limiting device is shown since the device can be symmetrically implemented. A symmetry axis S is indicated as a dash-dotted line S. The current limiting device comprises a substrate 6 having a width W₆ and a superconducting strip 8 placed on the substrate 6 having a width W₈. In the configuration shown in Fig. 9, the superconducting strip 8 is coupled to a copper contact bar 10 through electrodes 2A, 2B via a conductive electrode layer 16. The superconducting strip 8 is symmetrically placed onto the substrate 6, i.e. in the configuration shown in Fig. 9, the left and right overlap of the substrate surface is equal to ΔW = 0.5 ×(W₆ - W₈). In the embodiment shown, the superconducting section 8 is symmetrically placed onto the substrate 6 so that ΔW on both sides of the central superconducting section 8 is equal. Due to the symmetric arrangement a uniform cooling can be achieved. Any thermal and or mechanical stress is then generally isotropically distributed. Hence, a relatively robust system is formed.

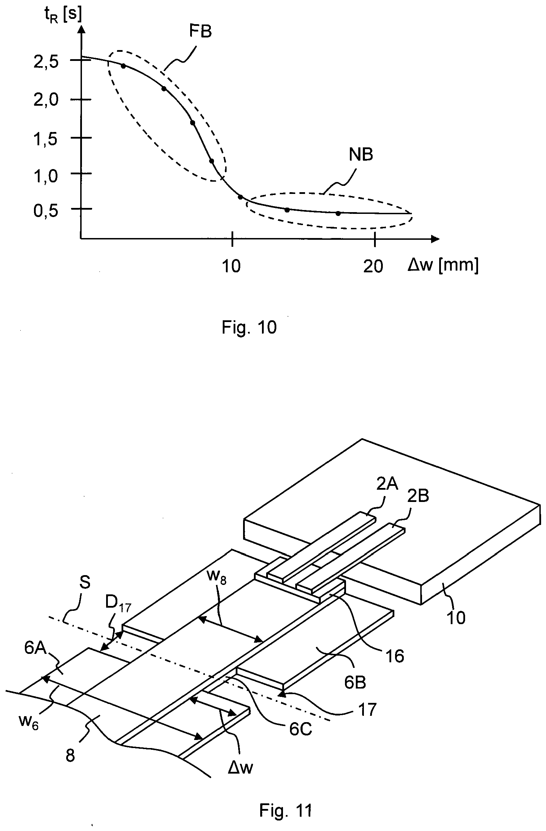

Investigations of the applicants show that by increasing ΔW, the resulting recovery time tᵣ can be decreased. Fig. 10 shows a diagram where the recovery time tᵣ is shown as a function of ΔW. One can see from the curve in Fig. 10 that the recovery time tᵣ drastically decreases when the substrate 6 is wider than the semiconductor layer. When increasing ΔW further, the recovery time tᵣ approaches an asymptotic limit. One can generally identify two regions. A first region FB, where ΔW is less than 10 mm, and a second region NB where ΔW is larger than 10 mm. In the later region NB the recovery time tᵣ saturates. Generally, the larger the substrate 6, the stronger is the effect as a heat sink as a heat dissipator. More specifically the larger the heat capacity of the substrate 6 and the weaker the thermal coupling between the substrate 6 and the superconducting section 8, the more likely nucleate boiling occurs.

Nucleate boiling is a type of boiling that takes place when the surface temperature of the substrate 6 is higher than the saturated fluid temperature and the heat flux is below the critical heat flux. Nucleate boiling NB is an efficient heat transfer mechanism compared to film boiling FB. Generally, nucleate boiling is preferred in this mechanism to dissipate heat from the superconductor 8 and/or substrate 6. In configurations where ΔW is small, for example less than 10 mm, predominantly film boiling FB occurs. In this condition, a vapor film of the surrounding cooling fluid can develop and depresses the heat transfer from the substrate 6 into the coolant liquid, such as liquid nitrogen. In Fig. 10, the regions representing film and nucleate boiling are indicated by FB and NB, respectively.

Hence, by varying ΔW, first a more efficient heat flux for cooling the device can be obtained, which leads to a decrease in recovery time tᵣ, and second, the recovery time tᵣ can be adjusted by changing ΔW.

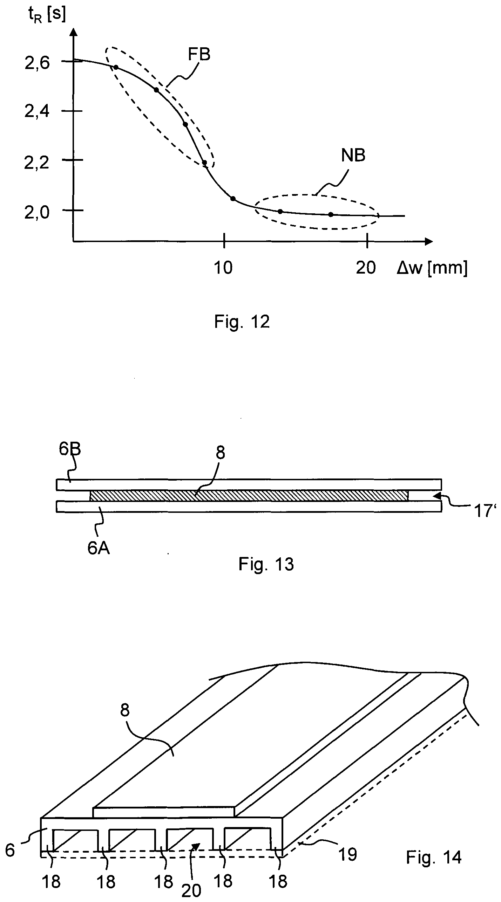

Fig. 11 shows another configuration for a current limiting device. The configuration shown in Fig. 11 has a substrate comprising two sections 6A and 6B that are separated from each other by a gap 17. The distance or width of the gap is referred to as D₁₇ in this drawing. The rest of the configuration is similar to what is disclosed in Fig. 9. Line S indicates the middle distance between the opposing edges of the substrate sections 6A , 6B and can be referred to as a symmetry axis. Investigations of the applicant show that by changing the distance D₁₇, i.e. the dimension of the gap 17, leads to a change in the recovery time tᵣ. Fig. 12 shows a diagram for the recovery time tᵣ as a function of ΔW wherein the gap is assumed to have an extension of D₁₇ = 18 mm. Again, the recovery time tᵣ decreases with increasing ΔW. One can identify a film boiling region FB and a nucleate boiling region NB. The gap 17 is symmetrically arranged between the two terminals, where only one terminal 10 is explicitly shown in Fig. 11. A symmetric configuration of the current limiting device, especially the symmetric combination of substrate 6, superconducting section 8 and terminal 10 in the shown arrangement can lead to a uniform thermal distribution and thereby better cooling and an improved durability of the device.

When comparing the absolute values of the recovery times tᵣ, as shown in Fig. 12 with a recovery time tᵣ in Fig. 10, one notices that the gap 17 leads to an increase in recovery time tᵣ.

One may contemplate of other means or strategies for adjusting a recovery time in a current limiting device. Figs. 13 - 16 show additional or alternative approaches.

Fig. 13 shows a configuration where the superconducting section 8 is sandwiched between two substrates 6A and 6B. By sandwiching the superconducting section 8 both substrate sections 6A and 6B may act as heat sinks from both sides. This can lead to a better heat transport and therefore cooling of the superconducting section 8. At the lateral edges of the superconducting section 8, a gap 17 limited by the upper and lower substrate sections can be present. By varying the sizes of the substrate sections 6A and 6B, the heat flux and eventually the recovery time can be adjusted.

Fig. 14 shows a perspective view of an arrangement where the superconducting section 8 is placed on a substrate section 6. The substrate 6 has protruding fins 18 distal from the face where the superconducting section 8 is placed. The fins 18 lead to a better heat dissipation of the substrate 6. Optionally, an additional substrate plate 19 can be placed on the protrusions or fins 18 thereby forming channels 20 through which coolant fluid can flow.

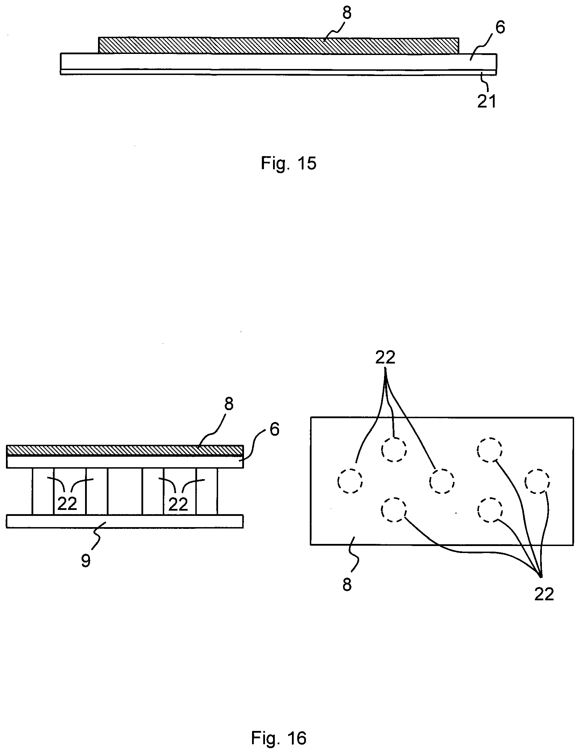

Fig. 15 shows a configuration where a substrate 6 has a functionalized coating or surface 21. For example, the first surface facing away from the superconducting section 8 has a roughness that is adapted to create nucleate boiling in a coolant liquid. The coating or surface treatment 21 can be a boiling enhancement layer. The functionalized layer 21 may increase the boiling heat transfer coefficient and the critical heat flux. For example, the functionalized layer 21 contains micro-pores in one embodiment.

Fig. 16 shows a configuration where the substrate 6 is provided with spacer elements, e.g. posts, columns or rods 22 that separate the substrate 6 from a substrate plate 19. The posts, rods or columns as shown in the right drawing of Fig. 16 are alternatingly arranged on the area of the substrate 6. One may structure the spacer elements 22 using chemical vapor deposition techniques. In some embodiments the spacer elements 22 are soldered to the substrate 6 and substrate plate 19 with a metal material. Optionally, the substrate plate 19 can have a functionalized coating or surface 21 to enhance a nucleate boiling process (not shown).

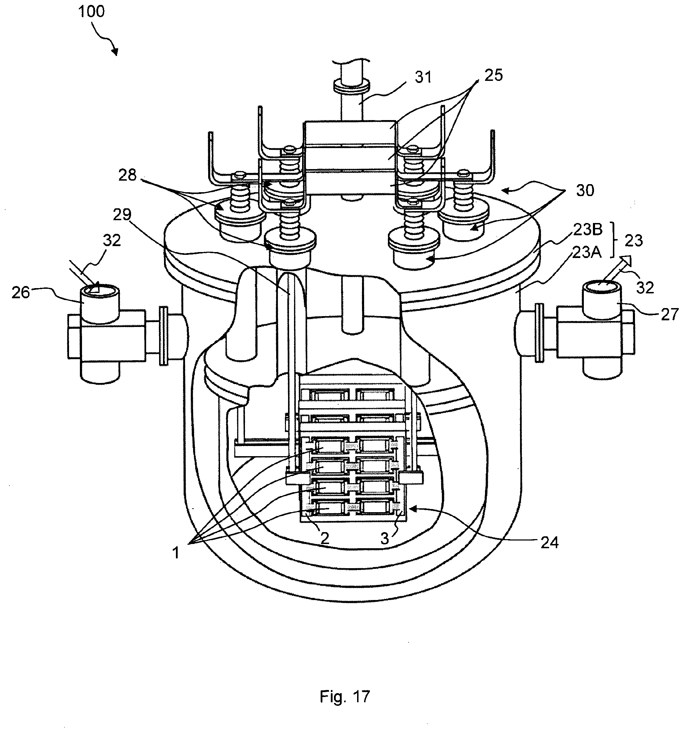

Fig. 17 shows a current limiter arrangement 100 in which a plurality of current limiting devices can be used. The current limiter arrangement 100 has a housing 23 comprising a bucket-shaped container or body 23A and a lid 23B. The housing 23 has an inlet 26 and an outlet 27 so that cryogenic fluid as a coolant fluid 32 can enter the interior of the housing. In the interior of the housing, a fault current limiter device 24 is positioned. The fault current limiter device 24 comprises a plurality of current limiting devices 1, as for example, shown in the configurations of the preceding figures. The current limiting devices 1 are arranged in parallel and optionally also in series. Electrical current is fed to the terminals 2, 3 through massive wires 29. The wires 29 extend through the lid 23B and enter into sockets 28 and 30 to be coupled with, for example, a power line. There are shunt resistances 25 coupled between the sockets coupling to the terminals 2, 3. The current limiter arrangement 100 has a shaft 31 that can be used as a fixture for the arrangement 1.

### Used reference characters:

- 1: current limiter arrangement
- 2, 3: terminal
- 4, 5: current limiter device
- 6, 7: substrate
- 8, 9: superconducting section
- 10, 11: contact bar
- 12: solder
- 13: buffer layer
- 14: superconducting layer
- 15: protective layer
- 16: electrode
- 17: gap
- 18: fin
- 19: substrate plate
- 20: channel
- 21: functionalization
- 22: post
- 23: housing
- 23A: lid
- 23B: body
- 24: current limiter device
- 25: shunt resistance
- 26: inlet
- 27: outlet
- 28: socket
- 29: wire
- 30: socket
- 31: shaft
- 32: cooling fluid
- 33: fin
- 100: current limiter arrangement

- Dᵢ: distance
- Wᵢ: width
- Lᵢ: length
- Tᵢ: thickness
- S: symmetry axis/plane
- Aᵢ: area
- Si: method step
- tᵣ: recovery time
- T_{c}: critical temperature
- I_{c}: critical current
- FB: film boiling regime
- NB: nucleate boiling regime

## Claims

1. A current limiter arrangement (1) for limiting an electric current between a first and a second terminal (2, 3) comprising;
a first current limiting device (4) and a second current limiting device (5) arranged between the first and the second terminal (2, 3);
the first and the second current limiting device (4, 5) each include a substrate (6, 7) having a substrate surface area (A₆) and a substrate thickness (T), and include a superconducting section (8, 9) arranged on the substrate (6, 7) and thermally coupled to the substrate (6, 7) thereby covering a coupling surface area (As) on the substrate (6, 7);
**characterized in that** at least one of the first or second current limiting device (4, 5) the substrate surface area (A₆) is larger than the coupling surface area (As);
**in that** each of the superconducting sections (8, 9) has a critical current value and **in that** the substrate surface areas (A₆), the substrate thicknesses (T) and/or the coupling surface areas (A₈) are configured to be adapted as a function of the critical current values.

2. The current limiter arrangement of claim 1, wherein the substrate surface areas (A₆), the substrate thicknesses (T) and/or the coupling surface areas (A₈) are configured to be adapted such that the recovery times of the first and the second current limiting device (4, 5) are within a predetermined range.

3. The current limiter arrangement of claim 1 or 2, wherein in at least one of the first or second current limiting device (4, 5) the substrate comprises at least two substrate sections (6A, 6B) that are at least section-wise separated from one another by a gap (17), and wherein the superconducting section (8) and/or a third substrate section (6C) partially bridges the gap (17).

4. The current limiter arrangement of any one of claims 1 - 3, wherein in at least one of the first or second current limiting device (4, 5) the substrate (6) has a width (W₆) that is larger than a width (W₈) of coupling surface area (8).

5. The current limiter arrangement of any one of claims 1 - 4, wherein the superconducting sections (8) have the same width.

6. The current limiter arrangement of any one of claims 1 - 5, wherein in at least one of the first or second current limiting device (4, 5) the substrate thickness (T₆) varies between the first and the second terminal (2, 3).

7. The current limiter arrangement of any one of claims 1 - 6, comprising further current limiting devices (4A - 4E) arranged between the first and the second terminal (2, 3), wherein each current limiting device (4A - 4E) includes a substrate (6) having a substrate surface area (A₆) and a substrate thickness (T₆), and a superconducting section (8) arranged on the substrate (6) and thermally coupled to the substrate (6) thereby covering a coupling surface area (A₈) on the substrate (6), wherein each of the superconducting sections (8) has a critical current value, and the substrate surface areas (A₆), the substrate thicknesses (T₆) and or the coupling surface areas (A₈) are configured to be adapted as a function of the critical current values.

8. The current limiter arrangement of any one of claims 1 - 7, further comprising a housing for a coolant liquid to pass around the current limiting devices (4, 5).

9. The current limiter arrangement of any one of claims 1 - 8, wherein in at least one of the current limiting devices (4, 5) the substrate (6, 7) and the superconducting section (6, 7) is a layered structure.

10. The current limiter arrangement of any one of claims 1 - 9, wherein in at least one of the current limiting devices (4, 5) the superconducting section (8, 9) comprises a buffer layer (13), a superconducting layer (14), and/or a protective layer (15).

11. The current limiter arrangement of any one of claims 1 - 10, wherein the substrate (6) comprises an electrically isolating material that is adapted to dissipate heat from the superconducting section (8) into a cooling liquid.

12. The current limiter arrangement of any one of claims 1 - 11, wherein the substrate (6) longitudinally extends between the first and the second terminal (2, 3), and wherein the width (W₆) of the substrate (6) extends beyond the coupling surface area (A₈) and varies at least piecewise between the first and the second terminal (2,3).

13. The current limiter arrangement of claim 12, wherein the substrate comprises at least two substrate sections (6A, 6B) that are at least section-wise separated from one another by a gap (17), and wherein the superconducting section (8) and/or a third substrate section (6C) partially bridges the gap (17).

14. A method for manufacturing a current limiter arrangement (1):
arranging a plurality of current limiting devices (4, 5) between a first and a second terminal (2, 3), wherein the current limiting devices (4, 5) each include a substrate (6, 7) having a substrate surface area (A₆) and a substrate thickness (T₆), and a superconducting section (8, 9) arranged on the substrate (8, 9) and thermally coupled to the substrate (6, 7) thereby covering a coupling surface area (A₈) on the substrate (6, 7);
electrically coupling the superconducting sections (8, 9) between the first and the second terminal (2, 3), wherein each of the superconducting sections has a critical current value;
**characterized in that**
at least one of the first or second current limiting device (4, 5) the substrate surface area (A6) is larger than the coupling surface area (A8); and **in that** of
adapting the substrate surface areas (A₆), the substrate thicknesses (T₆) and/or the coupling surface areas (A₈) as a function of the critical current values.

15. The method of claim 14, further comprising: compensating a difference in recovery times of the current limiting devices by varying the substrate surface areas (A₆), the substrate thicknesses (T₆) and/or the coupling surface areas (A₈) when the current limiter arrangement (1) is operated with predetermined operational parameters.

16. The method of claim 14 or 15, wherein the current limiter arrangement (1) is the current limiter arrangement of any one of claims 1 - 13.

## Patentansprüche

1. Strombegrenzungsanordnung (1) zur Begrenzung eines elektrischen Stroms zwischen einem ersten und einem zweiten Anschluss (2, 3), welche aufweist:
eine erste Strombegrenzungsvorrichtung (4) und eine zweite Strombegrenzungsvorrichtung (5), die zwischen dem ersten und dem zweiten Anschluss (2, 3) angeordnet sind;
wobei die erste und zweite Strombegrenzungsvorrichtung (4, 5) jeweils ein Substrat (6, 7) umfasst, das eine Substratoberfläche (A₆) und eine Substratdicke (T) aufweist, und einen supraleitenden Abschnitt (8, 9) umfasst, der auf dem Substrat (6, 7) angeordnet und thermisch mit dem Substrat (6, 7) gekoppelt ist, wodurch eine Kopplungsoberfläche (A₈) auf dem Substrat (6, 7) bedeckt wird;
**dadurch gekennzeichnet, dass** zumindest in einer von der ersten oder zweiten Strombegrenzungsvorrichtung (4, 5) die Substratoberfläche (A₆) größer als die Kopplungsoberfläche (A₈) ist; und
dass jeder der supraleitenden Abschnitte (8, 9) einen kritischen Stromwert aufweist, und
dass die Substratoberflächen (A₆), die Substratdicken (T) und/oder die Kopplungsoberflächen (A₈) in Abhängigkeit von den kritischen Stromwerten abgestimmt sind.

2. Strombegrenzungsanordnung nach Anspruch 1, wobei die Substratoberflächen (A₆), die Substratdicken (T) und/oder die Kopplungsoberflächen (A₈) derart abgestimmt sind, dass die Erholungszeiten der ersten und der zweiten Strombegrenzungsvorrichtung (4, 5) innerhalb eines vorgegebenen Bereichs sind.

3. Strombegrenzungsanordnung nach Anspruch 1 oder 2, wobei in zumindest einer der ersten oder der zweiten Strombegrenzungsvorrichtung (4, 5) das Substrat zumindest zwei Substratabschnitte (6A, 6B) aufweist, die zumindest abschnittsweise durch eine Lücke (17) getrennt voneinander sind, und wobei der supraleitende Abschnitt (8) und/oder ein dritter Substratabschnitt (6C) die Lücke (17) teilweise überbrückt.

4. Strombegrenzungsanordnung nach einem der Ansprüche 1 bis 3, wobei in zumindest einer der ersten oder zweiten Strombegrenzungsvorrichtung (4, 5) das Substrat (6) eine Breite (W₆) aufweist, die größer als eine Breite (W₈) der Kopplungsoberfläche (8) ist.

5. Strombegrenzungsanordnung nach einem der Ansprüche 1 bis 4, wobei die supraleitenden Abschnitte (8) die gleiche Breite aufweisen.

6. Strombegrenzungsanordnung nach einem der Ansprüche 1 bis 5, wobei in zumindest einer der ersten oder zweiten Strombegrenzungsvorrichtung (4, 5) die Substratdicke (T₆) zwischen dem ersten und dem zweiten Anschluss (2, 3) variiert.

7. Strombegrenzungsanordnung nach einem der Ansprüche 1 bis 6, welche weitere Strombegrenzungsvorrichtungen (4A - 4E) aufweist, die zwischen dem ersten und dem zweiten Anschluss (2, 3) angeordnet sind, wobei jede Strombegrenzungsvorrichtung (4A - 4E) ein Substrat (6), das eine Substratoberfläche (A₆) und eine Substratdicke (T₆), und einen supraleitenden Abschnitt (8) umfasst, der auf dem Substrat (6) angeordnet und thermisch mit dem Substrat (6) gekoppelt ist, wodurch eine Kopplungsoberfläche (A₈) auf dem Substrat (6) bedeckt wird, wobei jeder der supraleitenden Abschnitte (8) einen kritischen Stromwert aufweist und die Substratoberflächen (A₆), die Substratdicken (T₆) und/oder die Kopplungsoberflächen (A₈) in Abhängigkeit von den kritischen Stromwerten abgestimmt sind.

8. Strombegrenzungsanordnung nach einem der Ansprüche 1 bis 7, welche ferner ein Gehäuse für eine um die Strombegrenzungsvorrichtungen (4, 5) herumfließende Kühlflüssigkeit aufweist.

9. Strombegrenzungsanordnung nach einem der Ansprüche 1 bis 8, wobei in zumindest einer von den Strombegrenzungsvorrichtungen (4, 5) das Substrat (6, 7) und der supraleitende Abschnitt (6, 7) eine geschichtete Struktur ist.

10. Strombegrenzungsanordnung nach einem der Ansprüche 1 bis 9, wobei in zumindest einer der Strombegrenzungsvorrichtungen (4, 5) der supraleitende Abschnitt (8, 9) eine Pufferschicht (13), eine supraleitende Schicht (14) und/oder eine Schutzschicht (15) aufweist.

11. Strombegrenzungsanordnung nach einem der Ansprüche 1 bis 10, wobei das Substrat (6) ein elektrisch isolierendes Material aufweist, das eingerichtet ist, Hitze von dem supraleitenden Abschnitt (8) in die Kühlflüssigkeit abzuführen.

12. Strombegrenzungsanordnung nach einem der Ansprüche 1 bis 11, wobei sich das Substrat (6) longitudinal zwischen dem ersten und dem zweiten Anschluss (2, 3) erstreckt, und wobei sich die Breite (W₆) des Substrats (6) über der Kopplungsoberfläche (A₈) hinaus erstreckt und zumindest abschnittsweise zwischen dem ersten und dem zweiten Anschluss (2, 3) variiert.

13. Strombegrenzungsanordnung nach Anspruch 12, wobei das Substrat zumindest zwei Substratabschnitte (6A, 6B) aufweist, die zumindest abschnittsweise durch eine Lücke (17) getrennt voneinander sind, und wobei der supraleitende Abschnitt (8) und/oder ein dritter Substratabschnitt (6C) die Lücke (17) teilweise überbrückt.

14. Verfahren zum Herstellen einer Strombegrenzungsanordnung (1):
Anordnen einer Mehrzahl von Strombegrenzungsvorrichtungen (4, 5) zwischen einem ersten und einem zweiten Anschluss (2, 3), wobei die Strombegrenzungsvorrichtungen (4, 5) jeweils ein Substrat (6, 7), das eine Substratoberfläche (A₆) und eine Substratdicke (T₆) aufweist, und einen supraleitenden Abschnitt (8, 9) umfassen, der auf dem Substrat (8, 9) angeordnet und thermisch mit dem Substrat (6, 7) gekoppelt ist, wodurch eine Kopplungsoberfläche (A₈) auf dem Substrat (6, 7) bedeckt wird;
elektrisches Koppeln der supraleitenden Abschnitte (8, 9) zwischen dem ersten und dem zweiten Anschluss (2, 3), wobei jeder der supraleitenden Abschnitte einen kritischen Stromwert aufweist;
**dadurch gekennzeichnet, dass**
zumindest in einer der ersten oder zweiten Strombegrenzungsvorrichtung (4, 5) die Substratoberfläche (A₆) größer als die Kopplungsoberfläche (A₈) ist; und
dass die Substratoberflächen (A₆), die Substratdicken (T₆) und/oder die Kopplungsoberflächen (A₈) in Abhängigkeit von den kritischen Stromwerten angepasst werden.

15. Verfahren nach Anspruch 14, welches ferner aufweist:
Kompensieren einer Differenz in den Erholungszeiten der Strombegrenzungsvorrichtungen durch Variieren der Substratoberflächen (A₆), der Substratdicken (T₆) und/oder der Kopplungsoberflächen (A₈), während die Strombegrenzungsanordnung (1) mit vorgegebenen Betriebsparametern betrieben wird.

16. Verfahren nach Anspruch 14 oder 15, wobei die Strombegrenzungsanordnung (1) die Strombegrenzungsanordnung gemäß einem der Ansprüche 1 bis 13 ist.

## Revendications

1. Agencement limiteur de courant (1) destiné à limiter un courant électrique entre des première et seconde bornes (2, 3), comprenant :
un premier dispositif de limitation de courant (4) et un second dispositif de limitation de courant (5) disposés entre les première et seconde bornes (2, 3) ;
les premier et second dispositifs de limitation de courant (4, 5) comprenant individuellement un substrat (6, 7) ayant une superficie de substrat (A₆) et une épaisseur de substrat (T), et comprenant une section supraconductrice (8, 9) disposée sur le substrat (6, 7) et couplée thermiquement au substrat (6, 7), recouvrant ainsi une superficie de couplage (A₈) du substrat (6, 7) ;
**caractérisé en ce que** la superficie de substrat (A₆) d'au moins l'un des premier ou second dispositifs de limitation de courant (4, 5) est supérieure à la superficie de couplage (A₈) ;
**en ce que** chacune des sections supraconductrices (8, 9) a une valeur de courant critique et **en ce que** les superficies de substrat (A₆), les épaisseurs de substrat (T) et/ou les superficies de couplage (A₈) sont configurées pour être adaptées en fonction des valeurs de courant critique.

2. Agencement limiteur de courant selon la revendication 1, dans lequel les superficies de substrat (A₆), les épaisseurs de substrat (T) et/ou les superficies de couplage (A₈) sont configurées pour être adaptées de sorte que les temps de restauration des premier et second dispositifs de limitation de courant (4, 5) s'inscrivent à l'intérieur d'une plage prédéterminée.

3. Agencement limiteur de courant selon la revendication 1 ou 2, dans lequel le substrat d'au moins l'un des premier ou second dispositifs de limitation de courant (4, 5) comprend au moins deux sections de substrat (6A, 6B) qui sont au moins séparées l'une de l'autre dans la direction de section par un espace (17), et dans lequel la section supraconductrice (8) et/ou une troisième section de substrat (6C) pontent partiellement l'espace (17).

4. Agencement limiteur de courant selon l'une quelconque des revendications 1 à 3, dans lequel le substrat d'au moins l'un des premier ou second dispositifs de limitation de courant (4, 5) a une largeur (W₆) qui est supérieure à une largeur (W₈) de la superficie de couplage (8).

5. Agencement limiteur de courant selon l'une quelconque des revendications 1 à 4, dans lequel les sections supraconductrices (8) ont la même largeur.

6. Agencement limiteur de courant selon l'une quelconque des revendications 1 à 5, dans lequel l'épaisseur de substrat (T₆) d'au moins l'un des premier ou second dispositifs de limitation de courant (4, 5) varie entre les première et seconde bornes (2, 3).

7. Agencement limiteur de courant selon l'une quelconque des revendications 1 à 6, comprenant en outre des dispositifs de limitation de courant (4A à 4E) disposés entre les première et seconde bornes (2, 3), dans lequel chaque dispositif de limitation de courant (4A à AE) comprend un substrat (6) ayant une superficie de substrat (A₆) et une épaisseur de substrat (T₆), et une section supraconductrice (8) disposée sur le substrat (6) et couplée thermiquement au substrat (6), recouvrant ainsi une superficie de couplage (A₈) du substrat (6), dans lequel chacune des sections supraconductrices (8) a une valeur de courant critique, et les superficies de substrat (A₆), les épaisseurs de substrat (T₆) et/ou les superficies de couplage (A₈) sont configurées pour être adaptées en fonction des valeurs de courant critique.

8. Agencement limiteur de courant selon l'une quelconque des revendications 1 à 7, comprenant en outre un boîtier permettant une circulation d'un liquide de refroidissement autour des dispositifs de limitation de courant (4, 5).

9. Agencement limiteur de courant selon l'une quelconque des revendications 1 à 8, dans lequel le substrat (6, 7) et la section supraconductrice (6, 7) d'au moins l'un des dispositifs de limitation de courant (4, 5) forment une structure en couche.

10. Agencement limiteur de courant selon l'une quelconque des revendications 1 à 9, dans lequel la section supraconductrice (8, 9) d'au moins l'un des dispositifs de limitation de courant (4, 5) comprend une couche tampon (13), une couche supraconductrice (14) et/ou une couche de protection (15).

11. Agencement limiteur de courant selon l'une quelconque des revendications 1 à 10, dans lequel le substrat (6) comprend un matériau isolant de l'électricité qui est apte à dissiper de la chaleur issue de la section supraconductrice (8) dans un liquide de refroidissement.

12. Agencement limiteur de courant selon l'une quelconque des revendications 1 à 11, dans lequel le substrat (6) s'étend longitudinalement entre les première et seconde bornes (2, 3), et dans lequel la largeur (W₆) du substrat (6) s'étend au-delà de la superficie de couplage (A₈) et varie au moins dans la direction de longueur de pièce entre les première et seconde bornes (2, 3).

13. Agencement limiteur de courant selon la revendication 12, dans lequel le substrat comprend au moins deux sections de substrat (6A, 6B) qui sont au moins séparées l'une de l'autre dans la direction de section par un espace (17), et dans lequel la section supraconductrice (8) et/ou une troisième section de substrat (6C) pontent partiellement l'espace (17).

14. Procédé de fabrication d'un agencement limiteur de courant (1), consistant à :
agencer une pluralité de dispositifs de limitation de courant (4, 5) entre des première et seconde bornes (2, 3), dans lequel les dispositifs de limitation de courant (4, 5) comprennent individuellement un substrat (6, 7) ayant une superficie de substrat (A₆) et une épaisseur de substrat (T₆), et une section supraconductrice (8, 9) disposée sur le substrat (8, 9) et couplée thermiquement au substrat (6, 7), recouvrant ainsi une superficie de couplage (A₈) du substrat (6, 7) ;
coupler électriquement les sections supraconductrices (8, 9) entre les première et seconde bornes (2, 3), dans lequel chacune des sections supraconductrices a une valeur de courant critique ;
**caractérisé en ce que**
la superficie de substrat (A₆) d'au moins l'un des premier ou second dispositifs de limitation de courant (4, 5) est supérieure à la superficie de couplage (A₈) ; et **en ce qu'**il consiste à
adapter les superficies de substrat (A₆), les épaisseurs de substrat (T₆) et/ou les superficies de couplage (A₈) en fonction des valeurs de courant critique.

15. Procédé selon la revendication 14, consistant en outre à : compenser une différence de temps de restauration des dispositifs de limitation de courant par une variation des superficies de substrat (A₆), des épaisseurs de substrat (T₆) et/ou des superficies de couplage (A₈) lorsque l'agencement limiteur de courant (1) est mis en oeuvre selon des paramètres fonctionnels prédéterminés.

16. Procédé selon la revendication 14 ou la revendication 15, dans lequel l'agencement limiteur de courant (1) est l'agencement limiteur de courant selon l'une quelconque des revendications 1 à 13.
